# EUROPÄISCHE PATENTSCHRIFT

(11) **EP 0 422 323 B1**
(45) Veröffentlichungstag und Bekanntmachung des Hinweises auf die Patenterteilung: **02.06.1993**
(21) Anmeldenummer: 90105086.4
(22) Anmeldetag: 17.03.1990
(51) Int. Cl.: C23C 14/20, C23C 14/35, C23C 14/38

(54) **Verwendung von Helium als Prozessgas bei der Beschichtung von Substraten aus Polymethylmethacrylat mit einer dünnen Schicht Aluminium**
Use of Helium as process gas for coating polymethylmethacrylat substrates with a thin aluminium layer
Utilisation d'helium comme gaz pour revêtir un substrat de polyméthylméthacrylate avec une couche mince de l'aluminium

(30) Priorität: 12.10.1989 DE 3934092
(43) Veröffentlichungstag der Anmeldung: 17.04.1991
(73) Patentinhaber: LEYBOLD AKTIENGESELLSCHAFT, D-63450 Hanau (DE)
(72) Erfinder: Sichmann, Eggo, Dipl.-Ing., D.6460 Gelnhausen (DE); Krug, Thomas, Dr., D-6450 Hanau (DE); Fritsche, Wolf-Eckart, Dipl.-Phys., D-8752 Kleinostheim (DE); Pöllmann, Martin, Dipl.-Ing., D-6455 Erlensee (DE)

(56) Entgegenhaltungen:
- EP-A- 0 086 930
- US-A- 3 516 915
- US-A- 4 131 530
- PATENT ABSTRACTS OF JAPAN, Band 13, Nr. 179 (C-590)[3527], 26 April 1989; & JP-A-18264
- VDI Verlag, Düsseldorf, DE, 1987: H. FREY et al.: "DÜNNSCHICHTTECHNOLOGIE", Seiten 108-133

## Beschreibung

Die Erfindung betrifft die Verwendung von Helium als Prozeßgas bei der Beschichtung von Substraten aus Polymethylmethacrylat mit einer dünnen Aluminiumschicht mittels einer Gleichstromsputtervorrichtung mit einer mit einem Aluminium-Target bestückten Sputterkatode.

Durch das Fachbuch "Dünnschicht-Technologie", Herausgeber H. Frey et al., VDI-Verlag, Düsseldorf, 1987, Seite 109 ff, ist es allgemein bekannt, elektrisch leitende Substanzen mit einer DC- (Direct-Current) -Diodenanordnung zu zerstäuben, wozu die eine Elektrode, die Katode, am negativen Ausgang einer Gleichspannungsversorgung mit einer kV-Spannung und die andere Elektrode an Masse liegt, und wobei nach dem Evakuieren des Rezipienten dieser mit ≈ 10⁻² mbar Sputtergas geflutet wird, was zur anomalen Glimmentladung führt, deren Träger Elektronen und Sputtergasionen sind. Die Ionen bombardieren die Katode mit einigen keV und schlagen aus ihr Atome heraus. Diese Atome schlagen sich dann auf der Oberfläche der Anode - des Substrats - nieder.

Durch die EP 0086 930 ist weiterhin ein Verfahren bekannt, zum Herstellen dünner Schichten auf Substraten durch Katodenzerstäubungen von Targets aus Stoffen mit Elementen, die Atomgewichte gleich oder unterhalb 40 aufweisen, in Anwesenheit mindestens eines Inertgases oder Gasgemisches aus der Gruppe Helium und Stickstoff, wobei die dünnen Schichten aus Oxiden, Nitriden, Karbiden, Chloriden, Fluoriden mindestens eins der Elemente Lithium, Bor, Magnesium oder Aluminium aufweisen. Das bekannte Verfahren ist insbesondere geeignet für die Herstellung von Festelektrolytschichten für galvanische Zellen aus wenigstens einem Lithium-Nitrid-Halogenid.

Bei bekannten Verfahren wird eine Aluminiumschicht unmittelbar auf das Kunststoffsubstrat, z. B. auf Polycarbonat, aufgesputtert, und zwar ohne eine Zwischen- oder Haftschicht.

Dieses Verfahren hat den Nachteil, daß die Oxidationsbeständigkeit des Aluminiums sehr begrenzt ist, d. h. daß es zum Beispiel bei längerer Lagerung des beschichteten Substrats erfahrungsgemäß zu einer Schichtkorrosion kommen kann. Weiterhin hat es den Nachteil, daß es überhaupt nur bei bestimmten, ausgewählten Kunststoffen anwendbar ist.

Ein besonderes Problem besteht beim Beschichten von Kunststoffen aus der Gruppe der Polymethylacrylate, die beispielsweise als "Plexiglas" im Handel sind. Hier hat sich gezeigt, daß offenbar infolge der besonderen Empfindlichkeit dieses Werkstoffs gegen UV-Strahlung eine Ablösung der aufgesputterten Schicht bereits nach sehr kurzer Zeit erfolgt. Tatsächlich strahlt das Plasma beim Sputtern mit den Edelgasen Neon, Argon, Krypton und Xenon hauptsächlich UV-Strahlen im Wellenlängenbereich von 70 bis 105 nm aus.

Der vorliegenden Erfindung liegt deshalb die Aufgabe zugrunde, eine Möglichkeit zu schaffen, die geeignet ist, die Haftfestigkeit einer aufgesputterten Aluminiumschicht auf dem Substrat aus Polymethymetacrylat wesentlich zu verbessern, ohne daß herkömmliche bzw. bereits vorhandene Vorrichtungen oder Anlagen dafür ungeeignet sind bzw. ohne daß an diesen wesentliche oder kostspielige Umbauten oder Änderungen vorgenommen werden müssen.
Diese Aufgabe wird erfindungsgemäß dadurch gelöst, daß als Prozeßgas Helium (He) in die Beschichtungskammer eingeleitet wird.

Die Erfindung läßt die verschiedensten Ausführungsmöglichkeiten zu; eine davon ist in der anhängenden Zeichnung schematisch näher dargestellt, die eine Sputteranlage für das DC-Sputtern zeigt.

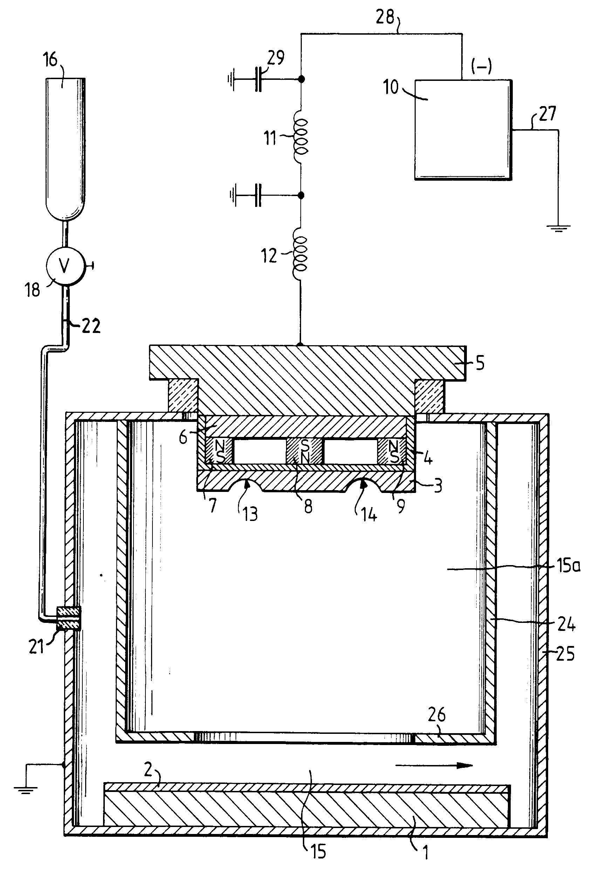

In der Zeichnung ist ein Kunststoffsubstrat 1 dargestellt, das mit einer dünnen, elektrisch leitenden Schicht 2 versehen werden soll. Diesem Substrat 1 liegt ein Target 3 aus Aluminium gegenüber, das zu zerstäuben ist. Das Target 3 steht über ein im Schnitt U-förmiges Element 4 mit einer Elektrode 5 in Verbindung, die auf einem Joch 6 ruht, welches zwischen sich und dem Element 4 drei Dauermagnete 7, 8, 9 einschließt. Die auf das Target 3 gerichteten Polaritäten der Pole der drei Dauermagnete 7, 8, 9 wechseln sich ab, so daß jeweils die Südpole der beiden äußeren Dauermagnete 7, 9 mit dem Nordpol des mittleren Dauermagneten 8 ein etwa kreisbogenförmiges Magnetfeld durch das Target 3 bewirken. Dieses Magnetfeld verdichtet das Plasma vor dem Target 3, so daß es dort, wo die Magnetfelder das Maximum ihres Kreisbogens besitzen, seine größte Dichte hat. Die Ionen im Plasma werden durch ein elektrisches Feld beschleunigt, das sich aufgrund einer Gleichspannung aufbaut, die von einer Gleichstromquelle 10 angegeben wird. Diese Gleichstromquelle 10 ist mit ihrem negativen Pol über zwei Induktivitäten 11, 12 mit der Elektrode 5 verbunden. Das elektrische Feld steht senkrecht auf der Oberfläche des Targets 3 und beschleunigt die positiven Ionen des Plasmas in Richtung auf dieses in der Prozeßkammer 25 bzw. im Behälter 24 angeordnete Target 3. Hierdurch werden mehr oder weniger viele Atome oder Aluminium-Partikel aus dem Target 3 herausgeschlagen, und zwar insbesondere aus den Gebieten 13, 14, wo die Magnetfelder ihre Maxima haben. Die zerstäubten Atome oder Partikel wandern in Richtung auf das Substrat 1 aus Polymethylmetacrylat, das sich unterhalb der Blende 26 am Boden des Behälters 25 befindet, wo sie sich als dünne Schicht 2 niederschlagen.

Für die Steuerung der dargestellten Anordnung kann ein Prozeßrechner vorgesehen werden, der Meßdaten verarbeitet und Steuerungsbefehle abgibt. Diesem Prozeßrechner können beispielsweise die Werte des gemessenen Partialdrucks in der Prozeßkammer 15 zugeführt werden. Aufgrund dieser und anderer Daten kann er zum Beispiel den Helium-Gasfluß an dem Behälter 16 über das in die Zuführungsleitung 22 eingeschaltete Ventil 18 regeln und die Spannung an der Kathode einstellen. Der Prozeßrechner ist auch in der Lage, alle anderen Variablen, zum Beispiel den Kathodenstrom zu regeln. Da derartige Prozeßrechner bekannt sind, wird auf eine Beschreibung ihres Aufbaus verzichtet.

Eine deutliche Steigerung der Haftfestigkeit der Schicht auf dem Polymethylmethacrylat-Substrat 1 ist das Ergebnis der Verwendung von Helium-Gas als Prozeß- bzw. Sputtergas.

### Auflistung der Einzelteile

- 1: Substrat
- 2: Schicht
- 3: Target
- 4: U-förmiges Element
- 5: Elektrode
- 6: Joch
- 7: Dauermagnet
- 8: Dauermagnet
- 9: Dauermagnet
- 10: Gleichstromquelle
- 11: Induktivität
- 12: Induktivität
- 13: Sputtergraben (Gebiet)
- 14: Sputtergraben (Gebiet)
- 15, 15a: Raum, Beschichtungskammer
- 16: Gasbehälter
- 18: Ventil
- 21: Einlaßstutzen
- 22: Gaszuführungsleitung
- 24: Behälter
- 25: Behälter, Prozeßkammer
- 26: Blende
- 27: elektrischer Anschluß (Masse-Leitung)
- 28: elektrischer Anschluß
- 29: Kondensator

## Patentansprüche

1. Verwendung von Helium als Prozeßgas bei der Beschichtung von Substraten aus Polymethylmethacrylat mit einer dünnen Aluminium-Schicht mittels einer Gleichstrom-Sputtervorrichtung mit einer mit einem Aluminiumtarget bestückten Sputterkatode.

## Claims

1. Use of helium as a process gas for coating polymethylacrylate substrates with a thin aluminium layer by means of a DC sputtering device with a sputter cathode having an aluminium target.

## Revendications

1. Utilisation d'hélium comme gaz de procédé dans le revêtement de substrat en polyméthacrylate de méthyle avec une couche mince d'aluminium au moyen de pulvérisation cathodique en courant continu avec une cathode de pulvérisation garnie d'une cible en aluminium.
